(19) Europäisches Patentamt
European Patent Office
Office européen des brevets

(11) **EP 2 636 108 B1**

(12) **EUROPÄISCHE PATENTSCHRIFT**

(45) Veröffentlichungstag und Bekanntmachung des Hinweises auf die Patenterteilung:
**29.03.2017 Patentblatt 2017/13**

(21) Anmeldenummer: **10797985.8**

(22) Anmeldetag: **03.11.2010**

(51) Int Cl.:
*H01S 3/04* *(2006.01)*  *H01S 5/024* *(2006.01)*
*H03K 3/57* *(2006.01)*  *H05K 7/20* *(2006.01)*
*H01L 23/473* *(2006.01)*

(86) Internationale Anmeldenummer:
**PCT/DE2010/075118**

(87) Internationale Veröffentlichungsnummer:
**WO 2012/059074 (10.05.2012 Gazette 2012/19)**

(54) **HOCHSPANNUNGSSCHALTER MIT KÜHLEINRICHTUNG**

HIGH-VOLTAGE SWITCH WITH COOLING DEVICE

INTERRUPTEUR HAUTE TENSION DOTÉ D'UN DISPOSITIF DE REFROIDISSEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**11.09.2013 Patentblatt 2013/37**

(73) Patentinhaber: **Bergmann Messgeräte Entwicklung KG**
**82418 Murnau (DE)**

(72) Erfinder: **BERGMANN, Thorald Horst**
**82418 Murnau (DE)**

(74) Vertreter: **Patentanwälte Lambsdorff & Lange**
**Dingolfinger Strasse 6**
**81673 München (DE)**

(56) Entgegenhaltungen:
**EP-A1- 0 844 812   DE-A1- 3 908 996**
**DE-A1- 4 017 749   JP-A- 2010 212 561**
**US-A- 5 802 087**

**Beschreibung**

Die vorliegende Erfindung betrifft einen Hochspannungsschalter mit Kühleinrichtung gemäß dem unabhängigen Patentanspruch 1 und eine Verwendung eines derartigen Hochspannungsschalters als Pockelszellen-Ansteuerschaltung.

Für das Schalten von Laserpulsen werden optische Schalter oder Modulatoren verwendet, die entweder innerhalb oder außerhalb des Laser-Resonators im Strahlengang angeordnet werden können. Bei den optischen Modulatoren unterscheidet man prinzipiell zwischen elektrooptischen Modulatoren und akustooptischen Modulatoren. Ein wichtiger Parameter bei dem Einsatz von optischen Modulatoren ist die erreichbare Schaltzeit. Bei akustooptischen Modulatoren wird die erreichbare Schaltzeit durch die Schallgeschwindigkeit und den Laserstrahl-Durchmesser begrenzt, sodass in manchen Fällen die Schaltflanken von akustooptischen Modulatoren zu langsam sind, um beispielsweise Vor- oder Nachpulse in einem kurzen Abstand zum Hauptpuls effektiv zu unterdrücken. Dem gegenüber sind elektrooptische Modulatoren in jüngster Vergangenheit in Richtung auf höhere Taktraten weiterentwickelt worden, sodass sie in der Lage wären, akustooptische Modulatoren bei bestimmten Laser-Anwendungen zu ersetzen, da sie sich durch wesentlich kürzere, elektronisch bedingte Schaltflanken auszeichnen.

Elektrooptische Modulatoren sind im Regelfall so aufgebaut, dass sie eine Pockelszelle als eigentliches optisches Schaltelement mit veränderbaren optischen Eigenschaften und ein polarisations-selektives Element wie beispielsweise einen reflektierenden Analysator mit unveränderbaren optischen Eigenschaften aufweisen. Eine Pockelszelle weist im Allgemeinen einen doppelbrechenden Kristall auf, welcher in geeigneter Weise zu einem einfallenden monochromatischen und polarisierten Lichtstrahl ausgerichtet ist und an den eine elektrische Spannung in der Größenordnung von einigen 100 V bis einigen Kilovolt angelegt wird. In Verbindung mit dem polarisations-abhängigen optischen Element kann die Pockelszelle das Licht in Abhängigkeit von der an sie angelegten elektrischen Spannung

(a) an- oder abschalten oder

(b) auf zwei verschiedenen Pfaden durch ein optisches System lenken.

Die Pockelszelle kann durch eine geeignete schaltbare Hochspannungsversorgung zwischen zwei Zuständen hin und her geschaltet werden, in welchen der aus der Pockelszelle austretende Laserstrahl mit jeweils senkrecht aufeinander stehenden Polarisationsrichtungen linear polarisiert ist. Die Spannung, welche erforderlich ist, um die jeweils zwei genannten Zustände zu erreichen, ist eine Funktion der Kristallparameter und der verwendeten Wellenlänge des zu schaltenden Lichts. Es gibt Anwendungen von Pockelszellen, bei welchen diese schnell an- und abgeschaltet werden müssen, wobei beide Übergangszeiten im Bereich von wenigen Nanosekunden liegen müssen. Bei manchen Anwendungen muss nur eine dieser Übergangszeiten kurz sein, entweder das Anschalten oder das Abschalten, wobei die jeweils andere Übergangszeit durchaus im Bereich von Mikrosekunden liegen kann.

Ein derartiger, aus einer Pockelszelle und einer geeigneten schaltbaren Hochspannungsversorgung aufgebauter elektrooptischer Modulator kann beispielsweise verwendet werden, um kurze Laserpulse mit einer Dauer von wenigen Nanosekunden (ns) oder ultrakurze Laserpulse mit Pikosekunden (ps)- oder Femtosekunden (fs)-Dauer optisch zu schalten, d.h. die Intensität oder die Strahlrichtung der Laserpulse zu ändern. Derartige ultrakurze Laserpulse werden bekanntermaßen durch das Verfahren der Moden-Kopplung erzeugt. Daher haben Laserstrahlquellen für ultrakurze Pulse prinzipbedingt immer sehr hohe Wiederholraten (größer als Megahertz (MHz), typischerweise 40 - 200 MHz für Festkörper-Laser) und niedrige Pulsenergien (im Nanojoule-Bereich, typischerweise 0,1 - 50 nJ). Werden einzelne Pulse oder Pulsgruppen von ps- oder fs-Laserpulsen benötigt, so wird häufig eine Pockelszelle verwendet, um diese Pulse zu selektieren. In diesem Fall muss zunächst zwischen zwei Pulsen, welche die Laserstrahlquelle typischerweise in einem zeitlichen Abstand von 5 - 25 ns aussendet, die Spannung vollständig angeschaltet werden, um nach Durchlassen eines einzigen Laserpulses 5 - 25 ns später vollständig wieder abgeschaltet zu werden.

Ein generelles Ziel besteht darin, die maximal mögliche Repetitionsrate der Pockelszelle ständig zu steigern, um somit die Rate zu erhöhen, mit der durch die Pockelszelle Pulse oder Pulsgruppen selektiert werden können. Die maximale Repetitionsrate der Pockelszelle wird wesentlich bestimmt durch die maximale Repetitionsrate, mit der der die Pockelszelle ansteuernde Hochspannungsschalter betrieben werden kann.

Die Druckschrift DE 39 08 996 A1 offenbart einen Flüssigkeitskühlkörper zur Kühlung elektrischer Bauelemente, welcher aus einem keramischen Werkstoff aufgebaut sein kann und bei welchem Bauelemente auf zwei in verschiedenen Ebenen liegenden Oberflächen des Kühlkörpers angebracht sein können.

Die Druckschrift DE 40 17 749 A1 offenbart einen Flüssigkeitskühlkörper aus einem elektrisch isolierenden Material, auf dessen Oberflächen Halbleiterbauelemente aufgebracht sind.

Die Druckschrift JP 2010 212561 A offenbart einen Hochspannungsschalter, welcher auf einer Oberfläche eines von einem Kühlmedium durchströmbaren Kühlsubstrats angebracht ist, und dessen Verwendung als Ansteuerschaltung für eine Pockelszelle.

Die Druckschrift US 5,802,087 A offenbart eine Lasereinrichtung mit einem Laseroszillator, einer mit dem Laseroszillator verbundenen elektrischen Leistungsversorgung, einer mit elektrischen Komponenten der elektrischen Leistungsversorgung verbundenen Wärmesenke, und einer Kühlwasserversorgung zur Lieferung von Kühlwasser an den Laseroszillator und die Wärmesenke.

Es ist somit Aufgabe der vorliegenden Erfindung, einen Hochspannungsschalter anzugeben, welcher mit einer hohen Repetitionsrate betrieben werden kann. Diese Aufgabe wird durch die Merkmale des Patentanspruchs 1 gelöst. Vorteilhafte Ausgestaltungen und Weiterbildungen sind Gegenstand von Unteransprüchen sowie nebengeordneten Ansprüchen.

Ein erfindungsgemäßer Hochspannungsschalter ist mit einer Kühleinrichtung verbunden und weist die Merkmale des Patentanspruchs 1 auf.

Als Hochspannungstransistoren kann man im Prinzip beliebige schaltbare Transistoren mit beliebigen Spannungsfestigkeiten verwenden, z.B. MOSFETs, Bipolartransistoren, etc. Die Spannungsfestigkeit kann beispielsweise 100 V oder mehr betragen, wobei jedoch vorzugsweise Transistoren mit Spannungsfestigkeiten von 500 V oder mehr zum Einsatz kommen.

Die maximal mögliche Repetitionsrate eines Hochspannungsschalters wird unter anderem durch den maximal möglichen Verbrauch elektrischer Leistung an dem Hochspannungsschalter und der entsprechend abzuführenden Wärme bestimmt. In erster Näherung gilt hierfür die Formel

$$P = f_{REP} \times (a \times U^2 + b), \qquad (1)$$

wobei P die verbrauchte elektrische Leistung, $f_{REP}$ die Repetitionsrate, U die angelegte Hochspannung und a, b Konstanten sind.

Der erfindungsgemäße Hochspannungsschalter hat nun den Vorteil, dass eine sehr effiziente Wärmeabfuhr ermöglicht wird, da die Wärme lediglich durch eine Wand der Kühlplatte bis zu dem strömenden Kühlmedium fließen muss. Ein weiterer Vorteil des erfindungsgemäßen Hochspannungsschalters besteht darin, dass aufgrund des elektrisch isolierenden Materials der Kühlplatte keine nennenswerten parasitären Kapazitäten gebildet werden, sodass diesbezüglich keine Verluste durch Auf- und Entladung der Kapazitäten zu befürchten sind.

Das Kühlsubstrat kann im einfachsten Fall durch eine aus dem elektrisch isolierenden Material gefertigte Platte sein, welche von dem Kühlmedium angeströmt wird. Eine besonders praktikable Ausführungsform besteht jedoch darin, dass das Kühlsubstrat zumindest teilweise durch einen Hohlkörper gebildet wird, welcher von dem Kühlmedium durchströmt wird. In diesem Fall sind die Wände des Hohlkörpers aus dem elektrisch isolierenden Material gefertigt und in eine Wand ist eine Einlassöffnung und in dieselbe oder eine andere Wand ist eine Auslassöffnung für das Kühlmedium geformt.

Gemäß einer Ausführungsform des Hochspannungsschalters weist das elektrisch isolierende Material des Kühlsubstrats ein keramisches Material auf oder besteht daraus. Insbesondere weist dabei das keramische Material die Verbindung Aluminiumnitrid (AlN) auf oder besteht daraus. Das keramische Material Aluminiumnitrid weist bekanntermaßen eine hohe Wärmeleitfähigkeit auf, die ca. 180 W/mK beträgt.

Gemäß einer Ausführungsform weist das elektrisch isolierende Material des Kühlsubstrats ein beliebiges anderes keramisches Material oder ein beliebiges nicht-metallisches Material auf oder besteht aus diesen genannten Materialien, wobei vorzugsweise die Wärmeleitfähigkeit des keramischen Materials oder des nicht-metallischen Materials größer als 50 W/mK, vorzugsweise größer als 100 W/mK, oder vorzugsweise größer als 150 W/mK beträgt.

Gemäß einer Ausführungsform des Hochspannungsschalters weisen die Hochspannungstransistoren jeweils eine ebene Kühlfläche auf und sind mit ihrer Kühlfläche unmittelbar flächig auf der ebenen Oberfläche des Kühlsubstrats aufgebracht. Auf diese Weise kann ein optimaler Wärmeübergang zwischen den Hochspannungstransistoren einerseits und dem Kühlsubstrat andererseits gewährleistet werden.

Gemäß des erfindungsgemäßen Hochspannungsschalters ist ein Teil der Hochspannungstransistoren auf einer ersten Oberfläche des Kühlsubstrats angebracht und ein anderer, insbesondere verbleibender Teil der Hochspannungstransistoren ist auf einer zweiten Oberfläche des Kühlsubstrats angebracht, wobei die erste und die zweite Oberfläche in verschiedenen Ebenen liegen. Die erste und die zweite Oberfläche des Kühlsubstrats sind einander gegenüberliegend und in zueinander parallelen Ebenen angeordnet. Darüber hinaus ist die Hälfte der Hochspannungstransistoren auf der ersten Oberfläche und die andere Hälfte der Hochspannungstransistoren auf der zweiten Oberfläche angebracht sein.

Gemäß einer Ausführungsform des Hochspannungsschalters sind die Hochspannungstransistoren zu einer Push-Pull-Schaltung zusammengeschaltet. Dabei können erste Hochspannungstransistoren in Serie zwischen einem ersten Pol einer Spannungsquelle und einem Knoten geschaltet sein, und die zweiten Hochspannungstransistoren können in Serie zwischen einem zweiten Pol der Spannungsquelle und dem Knoten geschaltet sein. Dabei kann vorgesehen sein, dass die ersten Hochspannungstransistoren auf einer ersten Oberfläche des Kühlsubstrats und die zweiten Hochspannungstransistoren auf einer zweiten Oberfläche des Kühlsubstrats angebracht sind und die erste Oberfläche und die zweite Oberfläche einander gegenüberstehen und in zueinander parallelen Ebenen angeordnet sind.

Gemäß einer anderen Ausführungsform des Hochspannungsschalters sind die Hochspannungstransistoren zu einer Brückenschaltung, insbesondere zu einer Brückenschaltung mit H-Konfiguration, zusammengeschaltet. Auch bei dieser Ausführungsform kann vorgesehen sein, dass die Hochspannungstransistoren hälftig auf je einer ersten und einer zweiten Oberfläche des Kühlsubstrats angebracht sind.

Die beschriebene Art und Weise, die Hochspannungstransistoren hälftig auf zwei gegenüberliegenden Seiten des Kühlsubstrats anzubringen, ist besonders vorteilhaft, da zum einen die bereitgestellte Kühlleistung effizient ausgenutzt wird und zum anderen eine platzsparende Anordnung der Hochspannungstransistoren ermöglicht wird.

Ein erfindungsgemäßer Hochspannungsschalter kann ferner eine der Anzahl der Hochspannungstransistoren entsprechende Anzahl von Lade-/Entlade-Schaltungen enthalten, von denen jede mit einem Hochspannungstransistor des einen oder der mehreren Hochspannungstransistoren verbunden ist. Der innere Aufbau der Lade-/Entlade-Schaltungen ist nicht Gegenstand der vorliegenden Anmeldung. Diese können beispielsweise so aufgebaut sein, wie in der deutschen Patentschrift DE36 30 775 C2 beschrieben. In einer besonders vorteilhaften Ausführungsform sind dabei die Lade-/Entlade-Schaltungen ebenso auf dem Kühlsubstrat aufgebracht, wobei jede Lade-/Entlade-Schaltung in räumlicher Nähe zu dem ihr zugeordneten Hochspannungstransistor angeordnet sein kann. Alternativ dazu können die Lade-/Entlade-Schaltungen jedoch auch außerhalb des Kühlsubstrats angeordnet, etwa auf einer Platine, welche mit dem Kühlsubstrat verbunden ist.

Die vorliegende Erfindung bezieht sich ebenso auf die Verwendung eines erfindungsgemäßen Hochspannungsschalters in einer Pockelszellen-Ansteuerschaltung und auf die Verwendung einer entsprechend angesteuerten Pockelszelle als Pulsselektor in Verbindung mit einer Laserstrahlquelle. Die Pockelszelle kann dabei wahlweise im Laser-Resonator oder auch außerhalb des Laser-Resonators angeordnet werden.

Im Folgenden werden Ausführungsbeispiele der Erfindung anhand der Zeichnungen näher erläutert. Es zeigen:

Fig. 1A, B   eine Darstellung eines nicht erfindungsgemäßen Hochspannungsschalters gemäß einer Ausführungsform in einer seitlichen Querschnittsansicht (A) und einer perspektivischen Ansicht (B);

Fig. 2A, B   eine Darstellung eines erfindungsgemäßen Hochspannungsschalters gemäß einer Ausführungsform in einer seitlichen Querschnittsansicht (A) und einer perspektivischen Ansicht (B); und

Fig. 3   ein Schaltungsdiagramm eines Hochspannungsschalters in der Ausführungsform einer Push-Pull-Schaltung.

Insofern in der folgenden Beschreibung, den Patentansprüchen oder den Zeichnungen zum Ausdruck gebracht wird, dass Schaltungselemente miteinander "verbunden", "elektrisch "verbunden" oder "gekoppelt" sind, so kann dies bedeuten, dass die genannten Elemente direkt, d.h. ohne dazwischen befindliche weitere Elemente, miteinander gekoppelt sind. Es kann jedoch auch bedeuten, dass die genannten Elemente nicht direkt miteinander gekoppelt sind und dass weitere Elemente zwischen die genannten Elemente gekoppelt sind.

Insofern in den Figuren gleiche Bezugszeichen verwendet werden, so beziehen sich diese auf gleiche oder funktionsgleiche Elemente, so dass in diesen Fällen die Beschreibung dieser Elemente nicht wiederholt wird.

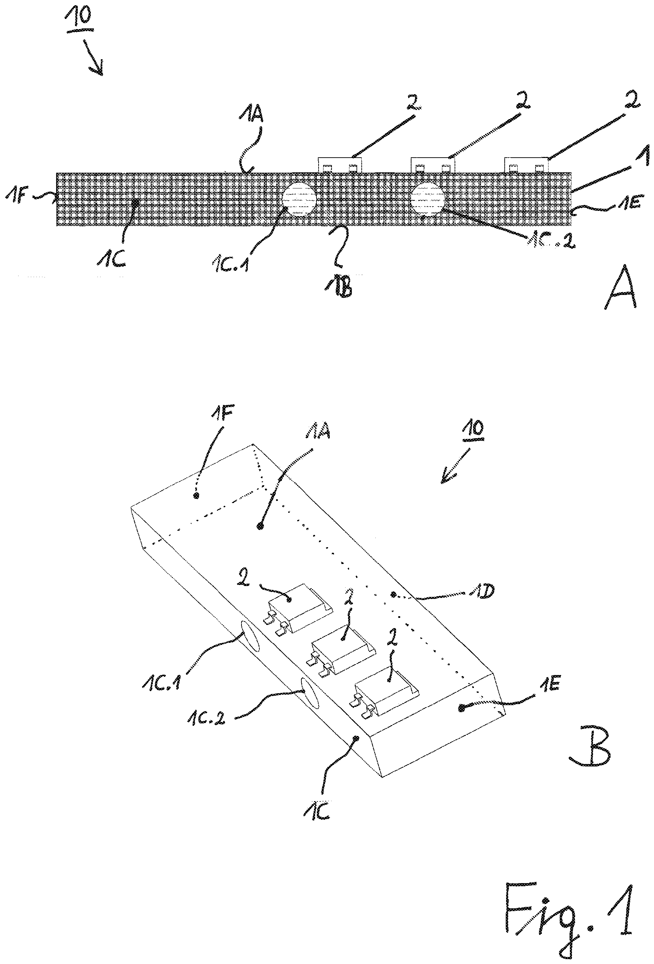

Fig. 1 zeigt einen nicht erfindungsgemäßen Hochspannungsschalter in einer seitlichen Querschnittsansicht (A) und einer perspektivischen Ansicht (B). Der Hochspannungsschalter 10 weist im Wesentlichen ein Kühlsubstrat 1 und eine Anzahl von auf einer Hauptoberfläche 1A des Kühlsubstrats 1 angebrachten Hochspannungstransistoren 2 auf. Das Kühlsubstrat 1 ist in Form eines quaderförmigen Hohlkörpers ausgebildet und weist somit zwei große Hauptoberflächen 1A und 1B, längsseitige Seitenflächen 1C und 10 und querseitige Seitenflächen 1E und 1F auf. Das Kühlsubstrat 1 ist aus dem Keramikmaterial Aluminiumnitrid (AlN) gefertigt und weist somit bekanntermaßen eine Wärmeleitfähigkeit von ca. 180 W/mK auf.

Das Kühlsubstrat 1 weist in einer längsseitigen Seitenfläche 1C eine Einlassöffnung 1C.1 und eine Auslassöffnung 1C.2 auf, durch die ein Kühlmedium wie im einfachsten Fall Wasser in den Innenraum des durch die Wände 1A - 1F gebildeten Hohlkörpers des Kühlsubstrats 1 und aus diesem heraus strömen kann. Die Einlaß- und Auslaßöffnungen 1C.1 und 1C.2 können selbstredend anstelle in die längsseitige Wand 1C alternativ auch in eine querseitige Wand 1E oder 1F oder unter Umständen auch in eine der Wände 1A oder 1B des Kühlsubstrats 1 geformt sein. Es können auch die Einlaß- und die Auslaßöffnung in verschiedene Wände des Kühlsubstrats 1 geformt sein. Die Hochspannungstransistoren 2 sind von identischer Bauart und weisen jeweils eine untere ebene Kühlfläche auf, mit der sie flächig auf der ersten Hauptoberfläche 1A des Kühlsubstrats 1 direkt aufgebracht sind. Die von den Hochspannungstransistoren 2 infolge des Verbrauchs elektrischer Leistung produzierte Wärme muss somit lediglich durch diese Wand des hoch-wärmeleitenden keramischen Materials AlN zu dem Kühlmedium transportiert werden.

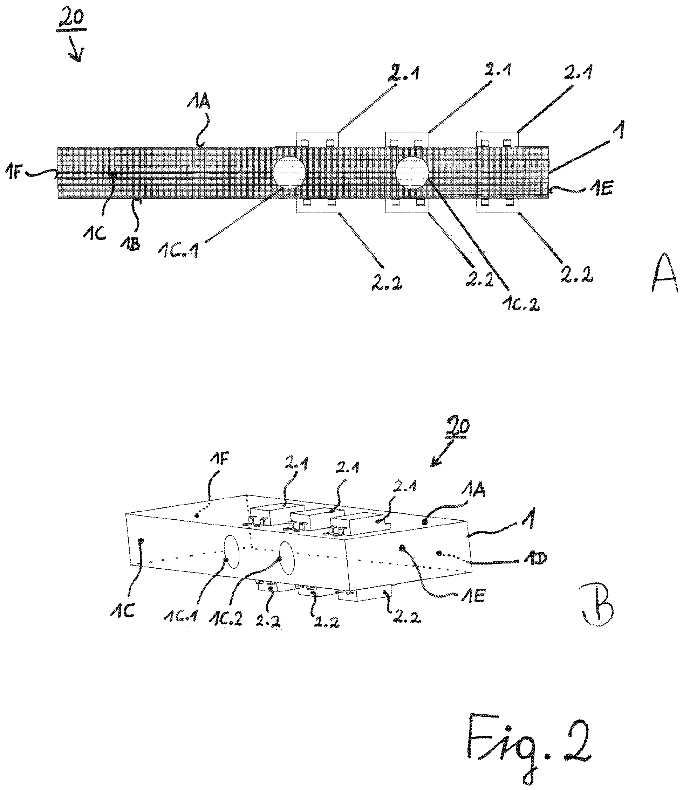

In der Fig. 2 ist ein erfindungsgemäßer Hochspannungsschalter gemäß einer Ausführungsform in einer seitlichen Querschnittsansicht (A) und einer perspektivischen Ansicht (B) schematisch dargestellt. Der Hochspannungsschalter 20 weist ein Kühlsubstrat 1 auf, welches in Aufbau und Funktionalität identisch mit dem Kühlsubstrat 1 des Ausführungsbeispiels der Figuren 1A, 1B ausgebildet ist, sodass die Einzelheiten hier nicht wiederholt werden müssen. Der Hochspannungsschalter 20 weist des Weiteren erste Hochspannungstransistoren 2.1 und zweite Hochspannungstransistoren 2.2 auf. Die ersten Hochspannungstransistoren 2.1 sind auf einer ersten Hauptoberfläche 1A des Kühlsubstrats 1 aufgebracht und die zweiten Hochspannungstransistoren 2.2 sind auf einer zweiten Hauptoberfläche 1B des Kühlsubstrats 1 aufgebracht. Wie in Fig. 2A zu sehen ist, sind die ersten und zweiten Hochspannungstransistoren 2.1 und 2.2 einander paarweise direkt gegenüberliegend auf der ersten und zweiten Hauptoberfläche 1A und 1B des Kühlsubstrats 1 aufgebracht. Dies wird in einem anderen Zusammenhang weiter unten noch eine Rolle spielen.

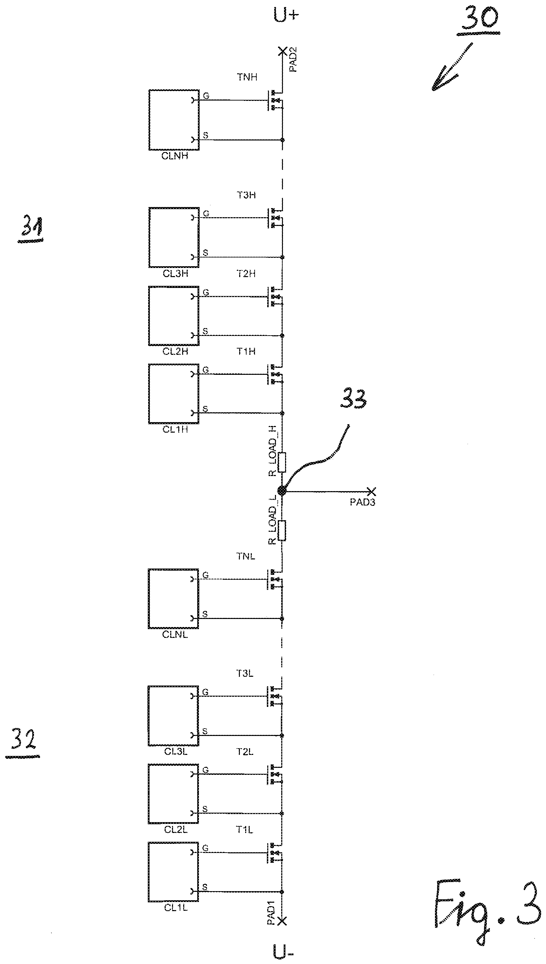

In der Fig. 3 ist ein Schaltungsdiagramm eines Hochspannungsschalters entsprechend einer Ausführungsform schematisch dargestellt. Der Hochspannungsschalter 30 der Fig. 3 ist als eine Push-Pull-Schaltung ausgebildet, die zwischen einem ersten Potentialanschluss U+ und einem zweiten Potentialanschluss U-geschaltet ist, wobei der erste und zweite Potentialanschluss mit den Anschlussklemmen einer Hochspannungsquelle verbunden sind. Der Hochspannungsschalter 30 besteht im Wesentlichen aus zwei Transistorketten 31 und 32 aus jeweils MOS-Feldeffekttransistoren (MOSFETs) T1H - TNH und T1L - TNL, die jeweils bezüglich ihrer Source-/Drain-Strecken in Serie geschaltet sind. Die MOSFETs T1H - TNH und T1L - TNL werden durch an sich bekannte Lade-/Entlade-Schaltungen CL1H - CLNH und CL1L - CLNL angesteuert, die jeweils mit dem Gate- und dem Source-Anschluss der MOSFETs T1H - TNH und T1L - TNL verbunden sind.

Der Hochspannungsschalter 30 weist somit eine erste Transistorkette 31 auf, innerhalb der erste MOSFET-Transistoren T1H - TNH in Serie geschaltet sind. Der Drain-Anschluss des MOSFET-Transistors TNH ist mit dem ersten Spannungspol U+ der Hochspannungsquelle verbunden, während am anderen Ende der Transistorkette der MOSFET-Transistor T1H mit seinem Source-Anschluss mit einem Widerstand $R_{LOAD\_H}$ verbunden ist, der seinerseits mit einem Knoten 33 verbunden ist. Der Hochspannungsschalter 30 weist ferner eine zweite Transistorkette 32 auf, in welcher die MOSFET-Transistoren T1L - TNL in Serie geschaltet sind. Der MOSFET-Transistor T1L ist mit seinem Source-Anschluss mit dem zweiten Spannungspol U- der Hochspannungsquelle verbunden, während der MOSFET-Transistor TNL mit seinem Drain-Anschluss mit einem Widerstand $R_{LOAD\_L}$ verbunden ist, der seinerseits mit dem Knoten 33 verbunden ist. Die Widerstände $R_{LOAD\_L}$ und $R_{LOAD\_R}$ sind lediglich als beispielhaft und nicht zwingend zu verstehen. Sie können also auch weggelassen werden. Es kann jedoch auch zusätzlich zu den Widerständen $R_{LOAD\_L}$ und $R_{LOAD\_R}$ ein weiterer Widerstand zwischen dem Knoten 33 und dem Anschlußpunkt PAD3 eingefügt werden.

Die MOSFETs T1H - TNH und T1L - TNL der Transistorketten 31 und 32 sind erfindungsgemäß an einem Kühlsubstrat 1 gemäß einer der Ausführungsformen der Figuren 1 und 2 angebracht. Eine bevorzugte Variante kann dadurch gebildet werden, dass gemäß der Ausführungsform der Fig. 2 die Transistoren T1H - TNH der ersten Transistorkette 31 auf einer ersten Oberfläche 1A des Kühlsubstrats 1 angebracht werden und die Transistoren T1L - TNL der zweiten Transistorkette 32 auf einer der ersten Oberfläche 1A gegenüberliegenden zweiten Oberfläche 1B des Kühlsubstrats 1 angebracht werden. Ein besonders vorteilhafter Aufbau ergibt sich dabei, wenn jeweils paarweise solche Transistoren der beiden Transistorketten gegenüberliegend angeordnet werden, die räumlich und potentialmäßig gleichermaßen von ihrem zugehörigen Spannungspol U+ oder U- beabstandet sind. So sollte der Transistor T1L gegenüber dem Transistor TNH, T2L gegenüber T(N-1)H usw. angeordnet werden. Dies ist deswegen vorteilhaft, da im Betrieb einer Push-Pull-Schaltung bei einem Schaltvorgang die Transistoren einer Transistorkette geschlossen, während gleichzeitig die Transistoren der anderen Transistorkette geöffnet werden. Bei einem solchen Schaltvorgang ergeben sich dann bei den Transistoren an ihrer Ausgangsseite Potentialänderungen von gleicher oder ähnlicher Amplitude, woraus sich besonders geringe kapazitive Umladungen und entsprechend geringe elektrische Verluste ergeben.

Die Lade-/Entlade-Schaltungen CL1H - CLNH und CL1L - CLNL sind in einer bevorzugten Ausführungsform ebenfalls auf dem Kühlsubstrat 1 montiert. Vorteilhafterweise sind sie auf der Oberfläche 1A des Kühlsubstrats 1 in Form einer Reihe derart montiert, dass jede Lade-/Entlade-Schaltung direkt neben dem ihr zugeordneten Hochspannungstransistor zu liegen kommt.

Die elektrischen Verbindungen auf dem Kühlsubstrat 1 können durch beliebige, an sich bekannte Techniken hergestellt werden. Zu erwähnen wären hier die DCB-Technik (Direct Copper Bonding) und die AMB-Technik (Active Metal Brazing). Ebenso gibt es an sich bekannte Techniken, mit welchen Widerstände, Induktivitäten und Kondensatoren auf Keramiksubstraten aufgebracht bzw. integriert werden. Auf diese Weise können z.B. die in Fig. 3 beispielhaft gezeigten Widerstände $R_{LOAD\_L}$ und $R_{LOAD\_R}$ und Anschlußflächen PAD1 - PAD3 aufgebracht werden.)

Der in der Fig. 3 gezeigte Hochspannungsschalter kann für eine Pockelszellen-Ansteuerschaltung verwendet werden. Zu diesem Zweck wird die Pockelszelle zwischen dem Knoten 33 (PAD3) mit ihrem ersten elektrischen Anschluss angeschlossen und mit ihrem zweiten elektrischen Anschluss mit dem zweiten Spannungspol U-der Hochspannungsquelle verbunden.

**Patentansprüche**

1. Hochspannungsschalter mit Kühleinrichtung, umfassend:

   eine Mehrzahl von Hochspannungstransistoren (2),
   ein aus einem elektrisch isolierenden Material gefertigtes und
   von einem Kühlmedium an- oder durchströmbares Kühlsubstrat (1), wobei
   erste Hochspannungstransistoren (2.1) auf einer ersten Oberfläche (1A) des Kühlsubstrats (1) angebracht ist
   und mit den ersten Hochspannungstransistoren (2.1) elektrisch verbundene zweite Hochspannungstransistoren
   (2.2) auf einer zweiten Oberfläche (1B) des Kühlsubstrats (1) angebracht sind, wobei die erste (1A) und die
   zweite Oberfläche (1B) in verschiedenen Ebenen liegen,
   wobei die ersten Hochspannungstransistoren (2.1) und die zweiten Hochspannungstransistoren (2.2) einander
   paarweise direkt gegenüberliegend auf der ersten und zweiten Hauptoberfläche (1A) und (1B) des Kühlsubstrats
   (1) aufgebracht sind.

2. Hochspannungsschalter nach Anspruch 1, bei welchem das elektrisch isolierende Material ein keramisches Material
   aufweist oder daraus besteht.

3. Hochspannungsschalter nach Anspruch 2, bei welchem das keramische Material die Verbindung Aluminiumnitrid
   aufweist oder daraus besteht.

4. Hochspannungsschalter nach einem der Ansprüche 1 bis 3, bei welchem
   die ersten Hochspannungstransistoren (2.1) und die zweiten Hochspannungstransistoren (2.2) jeweils eine Kühlfläche aufweisen und mit der Kühlfläche unmittelbar flächig auf der Oberfläche (1A) des Kühlsubstrats (1) aufgebracht
   sind.

5. Hochspannungsschalter nach einem der Ansprüche 1 bis 4, bei welchem
   das Kühlsubstrat (1) zumindest teilweise als ein Hohlkörper ausgebildet ist, dessen Wände (1A - 1F) aus dem
   elektrisch isolierenden Material gefertigt sind, wobei in eine Wand (1C) eine Einlassöffnung (1C.1) und in eine Wand
   (1C) eine Auslassöffnung (1C.2) für das Kühlmedium geformt sind.

6. Hochspannungsschalter nach einem der Ansprüche 1 bis 5, bei welchem
   das Kühlsubstrat (1) quaderförmig ausgebildet ist.

7. Hochspannungsschalter nach einem der Ansprüche 1 bis 6, bei welchem
   die erste (1A) und die zweite Oberfläche (1B) einander gegenüberstehen und in zueinander parallelen Ebenen
   angeordnet sind.

8. Verwendung eines Hochspannungsschalters nach einem der vorherigen Ansprüche als Ansteuerschaltung für eine
   Pockelszelle.

9. Verwendung nach Anspruch 8, nämlich Verwendung der Pockelszelle als Pulsselektor in Verbindung mit einer
   Laserstrahlquelle, wobei die Pockelszelle innerhalb oder außerhalb des Laserresonators angeordnet ist.

**Claims**

1. High-voltage switch with cooling device, comprising:

   a plurality of high-voltage transistors (2),
   a cooling substrate (1) made of an electrically insulating material and capable of being flown through by a cooling
   medium, wherein
   first high-voltage transistors (2.1) are disposed on a first surface (1A) of the cooling substrate (1) and second
   high-voltage transistors (2.2) electrically connected with the first high-voltage transistors (2.1) are disposed on
   a second surface (1B) of the cooling substrate (1), wherein the first (1A) and the second surface (1B) lie in
   different planes,
   wherein the first high-voltage transistors (2.1) and the second high-voltage transistors (2.2) are disposed in
   pairs directly opposite each other, respectively, on the first and second main surface (1A) and (1B) of the cooling substrate (1).

2. High-voltage switch according to claim 1, in which
   the electrically insulating material comprises or consists of a ceramic material.

3. High-voltage switch according to claim 2, in which
   the ceramic material comprises or consists of the compound aluminum nitride.

4. High-voltage switch according to anyone of claims 1 to 3, in which
   the first high voltage transistors (2.1) and the second high-voltage transistors (2.2) each comprise a cooling surface and are disposed with the cooling surface directly on the surface (1A) of the cooling substrate (1).

5. High-voltage switch according to anyone of claims 1 to 4, in which
   the cooling substrate (1) is at least partially formed as a hollow body, the walls (1A-1F) of which are made of the electrically insulating material, wherein in one wall (1C) an inlet opening (1C.1) and in one wall (1C) an outlet opening (1C.2) for the cooling medium are formed.

6. High-voltage switch according to anyone of claims 1 to 5, in which
   the cooling substrate (1) is formed as a cuboid.

7. High-voltage switch according to anyone of claims 1 to 6, in which
   the first (1A) and the second surface (1B) are lying opposite to each other and are arranged in planes which are parallel to each other.

8. Use of a high-voltage switch according to anyone of the preceding claims as drive circuit for a Pockels cell.

9. Use according to claim 8, namely used of the Pockels cell as pulse selector in connection with a laser beam source, wherein the Pockels cell is disposed inside or outside of the laser resonator.

**Revendications**

1. Interrupteur à haute tension avec un dispositif de refroidissement, comprenant :

   une pluralité de transistors à haute tension (2),
   un substrat de refroidissement (1) fabriqué en un matériau électriquement isolant et pouvant être parcouru ou traversé par un fluide de refroidissement, dans lequel
   des premiers transistors à haute tension (2.1) sont montés sur une première surface (1A) du substrat de refroidissement (1) et des deuxièmes transistors à haute tension (2.2) raccordés électriquement aux premiers transistors à haute tension (2.1) étant montés sur une deuxième surface (1B) du substrat de refroidissement (1), dans lequel les première (1A) et deuxième (1B) surfaces se situent dans des plans différents,
   dans lequel les premiers transistors à haute tension (2.1) et les deuxièmes transistors à haute tension (2.2) sont montés directement en vis-à-vis, par paires, sur la première et la deuxième surface principale (1A) et (1B) du substrat de refroidissement (1).

2. Interrupteur à haute tension selon la revendication 1, avec lequel le matériau électriquement isolant présente un matériau en céramique ou se compose de celui-ci.

3. Interrupteur à haute tension selon la revendication 2, avec lequel le matériau en céramique présente le composé de nitrure d'aluminium ou se compose de celui-ci.

4. Interrupteur à haute tension selon l'une des revendications 1 à 3, avec lequel
   les premiers transistors à haute tension (2.1) et les deuxièmes transistors à haute tension (2.2) présentent respectivement une surface de refroidissement et sont montés en nappe avec la surface de refroidissement directement sur la surface (1A) du substrat de refroidissement (1).

5. Interrupteur à haute tension selon l'une des revendications 1 à 4, avec lequel
   le substrat de refroidissement (1) est au moins partiellement réalisé en tant que corps creux dont les parois (1A-1F) sont fabriquées à partir du matériau électriquement isolant, dans lequel, pour le fluide de refroidissement, une ouverture d'entrée (1C.1) est formée dans une paroi (1C) et une ouverture de sortie (1C.2) étant formée dans une paroi (1C).

6. Interrupteur à haute tension selon l'une des revendications 1 à 5, avec lequel
le substrat de refroidissement (1) est réalisé en forme de parallélépipède.

7. Interrupteur à haute tension selon l'une des revendications 1 à 6, avec lequel
les première (1A) et deuxième (1B) surfaces se font face l'une l'autre et sont disposées dans des plans parallèles entre eux.

8. Utilisation d'un interrupteur à haute tension selon l'une des revendications précédentes en tant que circuit de commande pour une cellule de Pockels.

9. Utilisation selon la revendication 8, à savoir utilisation de la cellule de Pockels en tant que sélecteur impulsionnel en combinaison avec une source de rayonnement laser, dans laquelle la cellule de Pockels est disposée à l'intérieur ou à l'extérieur du résonateur laser.

Fig. 1

Fig. 2

U+

$\underline{30}$

TNH

CLNH

T3H

CL3H

T2H

CL2H

T1H

CL1H

R_LOAD_H

$\underline{33}$

PAD3

R_LOAD_L

TNL

CLNL

T3L

CL3L

T2L

CL2L

T1L

CL1L

$\underline{31}$

$\underline{32}$

PAD2

PAD1

U-

Fig.3

**IN DER BESCHREIBUNG AUFGEFÜHRTE DOKUMENTE**

**In der Beschreibung aufgeführte Patentdokumente**

- DE 3908996 A1
- DE 4017749 A1
- JP 2010212561 A
- US 5802087 A
- DE 3630775 C2